# EUROPEAN PATENT APPLICATION

(11) **EP 4 079 435 A1**
(43) Date of publication of application: **26.10.2022**
(21) Application number: 20901932.2
(22) Date of filing: 15.12.2020
(51) Int. Cl.: B23K 1/00, B23K 1/008, B23K 1/20, B23K 31/02

(54) **SOLDERING BOARD PRODUCTION METHOD AND SOLDERING DEVICE**

(30) Priority: 18.12.2019 JP 2019228406
(71) Applicant: Origin Company, Limited, Saitama-shi Saitama 338-0823 (JP)
(72) Inventor: OZAWA, Naoto, Saitama-shi, Saitama 338-0823 (JP); MATSUDA, Jun, Saitama-shi, Saitama 338-0823 (JP)
(74) Representative: Wallin, Nicholas James
(86) International application number: PCT/JP2020/046711
(87) International publication number: WO 2021/125158

(57) **Abstract**

Provided is a method for producing a board in which soldering is performed by means of a solder agent containing a solder and an included substance capable of boiling at a temperature lower than the melting temperature of the solder. In the method, a board is installed on a heating element which is heated to a first predetermined temperature higher than room temperature and lower than the boiling point of the included substance, the temperature of the board installed on the heating element is raised to a second predetermined temperature which is a temperature lower than the melting temperature of the solder and at which reduction is possible, oxides on the board at the second predetermined temperature are reduced by a reducing agent, the board is heated after reduction to a third predetermined temperature equal to or greater than the melting temperature of the solder, and the solder is melted. In addition, a soldering device is provided with: a heating unit for heating a board; a chamber in which the heating unit is accommodated; a reducing agent supply unit that supplies the reducing agent within the chamber; and a control device that controls the temperature of the heating unit and the supply of the reducing agent into the chamber so as to achieve the production method described above.

## Description

### TECHNICAL FIELD

The present disclosure relates to a method for manufacturing a soldered substrate, and a soldering device, and, in particular, to a method for manufacturing a soldered substrate and a soldering device which are capable of reducing a processing time.

### BACKGROUND ART

In a reflow soldering process of mounting an electronic component onto a substrate, formic acid may be used to reduce oxides present on the substrate, so as to eliminate need to clean a flux residue after soldering. An example of this reflow soldering process includes: placing an object to be joined onto a carrier plate in a chamber; reducing oxygen concentration in the chamber; supplying formic acid gas into the chamber, and turning on a heater to increase a temperature of the carrier plate and thus a temperature of the object to be joined to a reduction temperature, so as to remove an oxide film; increasing the temperature of the carrier plate and thus the temperature of the object to be joined to a joint temperature, at which solder is melted, for solder joint; tuning off the heater and decreasing the temperature of the carrier plate and thus the temperature of the object to be joined to solidify the solder; and taking out a soldered product, in which the solder is solidified, from the chamber (for example, see WO 2017/057651 pamphlet (Fig. 5 and the like)).

### SUMMARY OF THE INVENTION

### PROBLEM TO BE SOLVED BY THE INVENTION

In the above-described reflow soldering process, a considerable amount of time is required from time at which the object to be joined is input into the chamber to time at which the soldered product is made and taken out from the chamber. Thus, it is desired to reduce a processing time for a purpose of improving productivity.

The present disclosure has been made in view of the above-described problem and thus relates to provision of a method for manufacturing a soldered substrate and a soldering device capable of reducing a processing time.

### MEANS FOR SOLVING THE PROBLEM

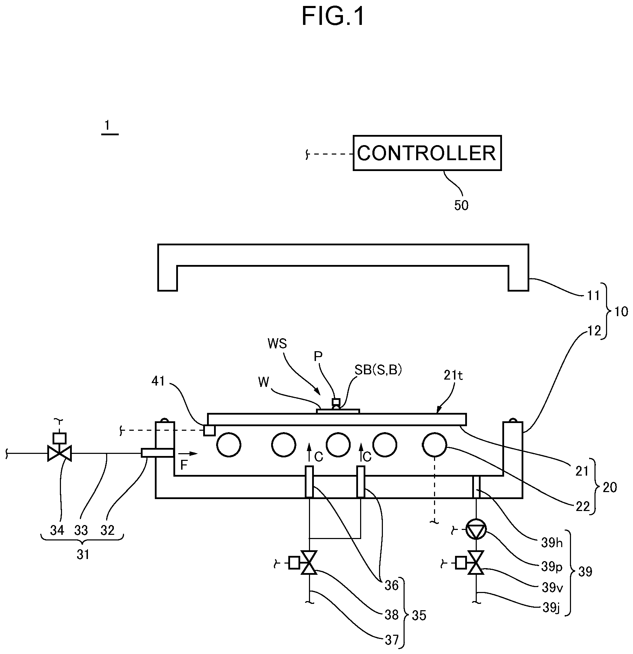

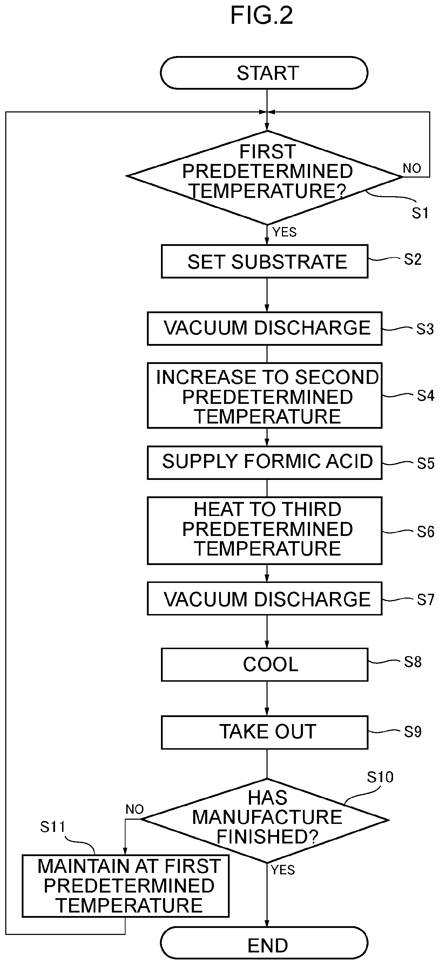

To achieve the above object, a method for manufacturing a soldered substrate according to the first aspect of the present disclosure is, as shown in FIGs. 2 and 1, for example, a method for manufacturing a soldered substrate, the soldered substrate being a substrate soldered by a solder agent SB, the solder agent SB containing solder S and a contained material B, the contained material B being able to be boiled at a temperature lower than a melting temperature of the solder S, and the method includes setting (S2) a substrate WS onto a heat generation body 20 heated at a first predetermined temperature, wherein the first predetermined temperature is lower than a boiling point of the contained material B and higher than an ordinary temperature; increasing (S4) a temperature of the substrate WS, which has been set on the heat generation body 20, to a second predetermined temperature, wherein the second predetermined temperature is lower than the melting temperature of the solder S and is a temperature at which an oxide on the substrate WS can be reduced; reducing (S5), in the presence of a reducing agent F, the oxide on the substrate WS, which has been heated to the second predetermined temperature; and after reducing (S5) the oxide on the substrate, melting (S6) the solder S by heating the substrate WS, which has been set on the heat generation body 20, to a third predetermined temperature, wherein the third predetermined temperature is equal to or higher than the melting temperature of the solder S.

With such a configuration, the substrate is set on the heat generation body that is heated to the higher temperature than the ordinary temperature. Thus, it is possible to reduce a time required to increase the temperature of the substrate to a reduction temperature and thus to reduce a processing time required to manufacture the soldered substrate.

As for a method for manufacturing a soldered substrate according to the second aspect of the present disclosure, in the method according to the first aspect, the contained material includes a solvent, wherein the solvent is able to be boiled at a temperature higher than the first predetermined temperature and equal to or lower than the second predetermined temperature, and the first predetermined temperature is lower than the second predetermined temperature.

With such a configuration, it is possible to reduce the processing time while avoiding spattering of the solvent.

As for a method for manufacturing a soldered substrate according to the third aspect of the present disclosure, as shown in FIGs. 2 and 1, for example, in the method according to the first or second aspect, the method includes taking out (S9) the substrate WS from the heat generation body 20 after melting (S6) the solder and before the temperature of the substrate is decreased to the second predetermined temperature.

With such a configuration, compared to a case where the substrate is taken out after the temperature thereof is decreased to a temperature near the ordinary temperature, it is possible to reduce the processing time.

As for a method for manufacturing a soldered substrate according to the fourth aspect of the present disclosure, as shown in FIGs. 2 and 1, for example, in the method according to the third aspect, the method includes maintaining the temperature (S11) of the heat generation body 20 to be equal to or higher than the first predetermined temperature after taking out the substrate (S9) and until a next substrate WS, that is to be processed subsequent to the substrate taken out in the taking out (S9) of the substrate, is set on the heat generation body 20.

With such a configuration, it is possible to eliminate a standby time when the substrate to be processed is switched, and it is also possible to reduce an amount of energy required to increase the temperature of the heat generation body to the first predetermined temperature, such energy being required when the temperature of the heat generation body becomes lower than the first predetermined temperature.

To achieve the above object, a soldering device according to the fifth aspect of the present disclosure includes, as shown in FIG. 1, for example, a heating section 20 configured to heat a substrate WS having a solder agent SB, wherein the solder agent SB contains solder S and a contained material B, and the contained material B is able to be boiled at a temperature lower than a melting temperature of the solder S; a chamber 10 configured to accommodate the heating section 20, wherein the chamber 10 is sealable; a reducing agent supply section 31 configured to supply a reducing agent F into the chamber 10, wherein the reducing agent F reduces an oxide on the substrate WS; and a controller 50 configured to control a temperature of the heating section 20 and supply of the reducing agent F into the chamber 10, wherein the controller 50 controls the heating section 20 and the reducing agent supply section 31 in a manner to: heat the heating section 20 to a first predetermined temperature before the substrate WS is set onto the heating section 20, wherein the first predetermined temperature is lower than a boiling point of the contained material B and higher than an ordinary temperature; heat the heating section 20 to increase a temperature of the substrate WS to a second predetermined temperature after the substrate WS is set on the heating section 20 that has been heated to the first predetermined temperature, wherein the second predetermined temperature is a temperature lower than the melting temperature of the solder and at which the oxide on the substrate WS can be reduced; supply the reducing agent F into the chamber 10 that has accommodated the substrate WS that has been heated to the second predetermined temperature; and heat the heating section 20 such that the temperature of the substrate WS reaches a third predetermined temperature after the oxide on the substrate WS is reduced, wherein the third predetermined temperature is equal to or higher than the melting temperature of the solder.

With such a configuration, the substrate is set on the heating section that is heated to the higher temperature than the ordinary temperature. Thus, it is possible to reduce the time required to increase the temperature of the substrate to the reduction temperature and thus to reduce the processing time required to execute soldering.

### ADVANTAGE OF THE INVENTION

With the present disclosure, the substrate is set on the heat generation body that is heated to the higher temperature than the ordinary temperature. Thus, it is possible to reduce the time required to increase the temperature of the substrate to the reduction temperature and thus to reduce the processing time required to execute soldering.

### BRIEF DESCRIPTION OF DRAWINGS

FIG. 1 is a schematic configuration view of a soldering device according to an embodiment.
FIG. 2 is a flowchart for explaining a procedure for a method for manufacturing a soldered substrate according to the embodiment.
FIG. 3 is a graph of an exemplary temperature profile in the method for manufacturing a soldered substrate according to the embodiment.

### DESCRIPTION OF EMBODIMENTS

This application is based on the Patent Application No. 2019-228406 filed on December 18, 2019 in Japan, the contents of which are hereby incorporated in its entirety by reference into the present application, as part thereof.

The present invention will become more fully understood from the detailed description given hereinbelow. Further range of application of the present invention will become clearer from the detailed description given hereinbelow. However, the detailed description and the specific embodiment are illustrated of desired embodiments of the present invention and are described only for the purpose of explanation. Various changes and modifications will be apparent to those ordinary skilled in the art on the basis of the detailed description.

The applicant has no intention to give to public any disclosed embodiment. Among the disclosed changes and modifications, those which may not literally fall within the scope of the patent claims constitute, therefore, a part of the present invention in the sense of doctrine of equivalents.

Description will hereinafter be made of each embodiment with reference to the drawings. The same or corresponding members are denoted with the same reference numerals in all the drawings, and their descriptions are not repeated.

First, with reference to FIG. 1, a description will be made on a soldering device 1 according to an embodiment. FIG. 1 is a schematic configuration view of the soldering device 1. The soldering device 1 is a device that executes reflow processing on a substrate-to-be-processed WS (hereinafter simply referred to as a "substrate WS") in which a solder agent SB and an electronic component P are provided on a substrate body W. The soldering device 1 includes a chamber 10, a heating section 20, a formic acid supply section 31, a cooling section 35, and a controller 50. Here, prior to a description on components of the soldering device 1, a description will be made on the solder agent SB that constitutes the substrate WS.

The solder agent SB contains solder S and a contained material B other than the solder S. The solder S is metal for fixing the electronic component P onto the substrate body W, and is typically an alloy containing lead and one of zinc, tin, or the like. However, the solder S may be lead-free solder. The solder S is solid at an ordinary temperature (a normal temperature at which neither heating nor cooling is performed, and typically an ambient temperature), and has a property of being melted at an inherent temperature (for example, 350 °C) that is higher than the ordinary temperature (a temperature at which the solder S is melted will be referred to as a "melting temperature"). The contained material B includes: binder that adjusts viscosity of the solder agent SB and expedites adherence of a material in the solder agent SB; and a solvent that disperses the solder S and the binder. In this embodiment, the contained material B has such a property that the contained material B can be boiled at a temperature lower than the melting temperature of the solder S (for example, boiled at 200 °C and 100 Pa (an absolute pressure)) within a pressure range generated during actuation of the soldering device 1 (in a series of steps in soldering processing). The solder agent SB is typically formed of a paste-like material that leaves no residue requiring cleaning after soldering. However, preform solder (including solder foils laminated into a chip-like shape) may be used. The solder S and the substrate body W may generate oxides when being exposed to oxygen.

The chamber 10 defines a space where the soldering processing for the substrate WS is executed. The chamber 10 has an upper lid 11 and a lower frame 12. In the chamber 10, the upper lid 11 can be moved in a manner to approach or separate from the lower frame 12 by an opening and closing mechanism (not illustrated). In this way, the chamber 10 can be opened and closed. The chamber 10 is configured to be sealed when closed (when the upper lid 11 is brought into contact with the lower frame 12). The sealable chamber 10 can have a lower internal pressure than an external pressure. Since soldering is preferably performed under vacuum (lower than the atmospheric pressure), the chamber 10 is configured to have a structure capable of withstanding a degree of vacuum that is at least suited for soldering or preferably a lower degree of vacuum (for example, approximately 50 Pa (the absolute pressure)) than the suited degree of vacuum for soldering. The chamber 10 is typically formed in a cuboid shape from a perspective of facilitating production thereof. However, the chamber 10 may be formed to have a curved outer peripheral wall from a perspective of pressure resistance. The chamber 10 is provided with: a formic acid nozzle 32 for introducing formic acid F; and a cooling nozzle 36 for introducing a cooling fluid C.

The heating section 20 can apply heat to the substrate WS and can thereby heat the substrate WS. The heating section 20 has: a plate 21 on which the substrate WS is placed; and a lamp 22 for heating the plate 21. In this embodiment, the plate 21 is formed in a board-like shape and arranged in the chamber 10. From a perspective of placement stability, in the plate 21, a placement surface 21t on which the substrate WS is placed is formed to be flat. Typically, a reverse side surface of the placement surface 21t is also formed to be flat. The plate 21 is formed such that an area of the placement surface 21t is larger than an area of the substrate WS. In the chamber 10, the plate 21 is typically installed in a manner that the placement surface 21t is horizontal. However, the plate 21 may be tilted with respect to the horizon (a direction in which the placement surface 21t expands may have a horizontal component and a vertical component) within a range where the placed substrate WS can remain being placed (within a range where the placed substrate W does not slip off). The lamp 22 is configured to be able to heat via the plate 21 the substrate WS which is placed on the plate 21. In this embodiment, the lamp 22 is arranged at a position below the plate 21 and near the plate 21 in the chamber 10. In this embodiment, the lamp 22 is configured that a plurality of infrared lamps is aligned along a back surface of the plate 21 at appropriate intervals. The plate 21 is formed of a material that can transfer heat generated by the lamp 22 to the substrate WS, and is typically formed of graphite. However, the plate 21 may be formed of metal with high thermal conductivity. Here, an amount of heat that is transferred from the lamp 22 to the substrate WS via the plate 21 corresponds to an amount of heat with which the temperature of the solder S on the substrate WS can be increased to a temperature at which the solder S can be melted. The plate 21 is typically configured that a temperature thereof can be increased to be higher than a melting point of the solder S on the substrate WS. The plate 21 is provided with a temperature sensor 41 that detects the temperature of the plate 21.

The formic acid supply section 31 has: a formic acid source (not illustrated); the above-described formic acid nozzle 32; a formic acid pipe 33 through which the formic acid F is introduced into the formic acid nozzle 32 from the formic acid source (not illustrated); and a formic acid control valve 34 that is disposed in the formic acid pipe 33. The formic acid source (not illustrated) has a vaporizing section that vaporizes the formic acid, and is configured to be able to supply the vaporized formic acid F into the chamber 10. The formic acid supply section 31 is configured to supply the vaporized formic acid F into the chamber 10 when the formic acid control valve 34 is opened, and is configured to intermit the supply of the formic acid F into the chamber 10 when the formic acid control valve 34 is closed. The formic acid F can reduce the oxides on the substrate WS and the solder S when supplied to the substrate WS and the solder S which are at the reduction temperature, and thus corresponds to a reducing agent. In addition, the formic acid supply section 31 supplies the formic acid F as the reducing agent, and corresponds to a reducing agent supply section. In the soldering device 1, by supplying the formic acid F to the substrate WS and the solder S which are at the reduction temperature, it is possible to reduce the oxides on the substrate WS and the solder S without using a flux.

The cooling section 35 has: a cooling fluid source (not illustrated); the above-described cooling nozzle 36; a cooling pipe 37 through which the cooling fluid C is introduced into the cooling nozzle 36 from the cooling fluid source (not illustrated); and a cooling control valve 38 that is disposed in the cooling pipe 37. In this embodiment, the cooling section 35 is provided with a plurality of the cooling nozzles 36. The cooling pipe 37 is branched into plural pipes on a downstream side of the cooling control valve 38 when seen in a flow direction of the cooling fluid C, and each of the branched cooling pipes 37 is connected to the respective cooling nozzle 36. The cooling section 35 is configured to supply the cooling fluid C into the chamber 10 when the cooling control valve 38 is opened, and is configured to intermit the supply of the cooling fluid C into the chamber 10 when the cooling control valve 38 is closed. As the cooling fluid C, gas is typically used, inert gas may be used as a type thereof, and air may be used from a perspective of cost reduction.

In addition to the formic acid supply section 31 and the cooling section 35 described above, a discharge section 39 is provided in the chamber 10. The discharge section 39 has: a discharge pipe 39j; a vacuum pump 39p that is disposed in the discharge pipe 39j; and a discharge control valve 39v that is also disposed in the discharge pipe 39j. One end of the discharge pipe 39j is connected to an outlet 39h provided in the chamber 10. The discharge section 39 is configured to discharge the fluid that is in the chamber 10 to the outside of the chamber 10 when the discharge control valve 39v is opened in a state where the vacuum pump 39p is actuated, and is configured to intermit discharge of the fluid to the outside of the chamber 10 when the discharge control valve 39v is closed in the same state.

The controller 50 controls operation of the soldering device 1. The controller 50 is connected to the heating section 20 in a wired or wireless manner, and is configured to be able to control an amount of heat generation of the lamp 22 (including no heat generation) by sending a control signal to the heating section 20. The controller 50 is also connected to the formic acid control valve 34 in the wired or wireless manner, and is configured to be able to control supply of the formic acid F into the chamber 10 through opening and closing operation of the formic acid control valve 34 by sending the control signal to the formic acid control valve 34. The controller 50 is also connected to the cooling control valve 38 in the wired or wireless manner, and is configured to be able to control supply of the cooling fluid C to the chamber 10 through opening and closing operation of the cooling control valve 38 by sending the control signal to the cooling control valve 38. The controller 50 is also connected to each of the vacuum pump 39p and the discharge control valve 39v in the wired or wireless manner, and is configured to be able to control discharge of the fluid in the chamber 10 through starting and stopping operation of the vacuum pump 39p and the opening and closing operation of the discharge control valve 39v by sending the control signal to the vacuum pump 39p and the discharge control valve 39v. The controller 50 is also connected to the temperature sensor 41 in the wired or wireless manner, and is configured to be able to receive a signal related to temperature detected by the temperature sensor 41. The controller 50 is also connected to the opening and closing mechanism (not illustrated) for moving the upper lid 11 of the chamber 10 in the wired or wireless manner, and is configured to be able to control opening and closing of the chamber 10 by sending the control signal to the opening and closing mechanism (not illustrated). The controller 50 is also connected to a robot hand (not illustrated) for carrying the substrate WS into and out of the chamber 10 in the wired or wireless manner, and is configured to be able to carry the substrate WS into and out of the chamber 10.

Subsequently, referring to FIG. 2, a description will be made on a method for manufacturing a soldered substrate using the soldering device 1. FIG. 2 is a flowchart for explaining a procedure for manufacturing a soldered substrate. In the following description on the method for manufacturing a soldered substrate, when the configuration of the soldering device 1 is described, FIG. 1 will appropriately be referred. The following description on the method for manufacturing a soldered substrate using the soldering device 1 will also serve as a description on operation of the soldering device 1. In an initial state before operation of the soldering device 1, the formic acid control valve 34, the cooling control valve 38, and the discharge control valve 39v are closed, and the lamp 22 and the vacuum pump 39p are stopped. When the soldering device 1 is activated, the controller 50 typically starts the vacuum pump 39p, and constantly operates the vacuum pump 39p during the operation of the soldering device 1, so as to control presence or absence of discharge of the fluid in the chamber 10 by opening and closing the discharge control valve 39v.

When the soldering device 1 starts working, the controller 50 turns on the lamp 22 to start heating the heating section 20, and determines whether a temperature of the heating section 20 is a first predetermined temperature (S1). Here, the first predetermined temperature is preferably an appropriate set value that is lower than a boiling point of the contained material B in the solder agent SB and higher than the ordinary temperature within a range of the pressure (typically a minimum pressure) generated by the time when reduction processing, which will be described below, is executed. The first predetermined temperature is preferably as high as possible within a permissible range. In this embodiment, the first predetermined temperature is set to 150 °C but can appropriately be changed according to a condition. In addition, the first predetermined temperature is not limited to a single point and may vary within a certain range. In addition, the ordinary temperature described herein is the normal temperature, at which neither heating or cooling is performed as described above, and is typically the ambient temperature. In this embodiment, the temperature of the plate 21, which is detected by the temperature sensor 41, is adopted as the temperature of the heating section 20. In the step of determining whether the temperature of the heating section 20 is the first predetermined temperature (S1), if the temperature of the heating section 20 is not the first predetermined temperature, the processing returns to the step of determining whether the temperature of the heating section 20 is the first predetermined temperature (S1).

On the other hand, in the step of determining whether the temperature of the heating section 20 is the first predetermined temperature (S1), if the temperature of the heating section 20 is the first predetermined temperature, the substrate WS is set onto the heating section 20 (a setting step: S2). Here, setting the substrate WS onto the heating section 20 corresponds to bringing the substrate WS into a state of receiving the heat from the heating section 20, and typically corresponds to placement of the substrate WS onto the placement surface 21t of the plate 21. In order to place the substrate WS onto the plate 21, the controller 50 opens the upper lid 11 of the chamber 10 via the opening and closing mechanism (not illustrated), and causes the robot hand (not illustrated) to carry the substrate WS into the chamber 10 and to place onto the plate 21. At a position above the plate 21, the robot hand (not illustrated) lowers the substrate WS vertically and places onto the plate 21. In this way, it is possible to prevent dust, which can be generated when the substrate WS is made to slide on the plate 21. When the substrate WS is placed onto the plate 21, the robot hand (not illustrated) moves out of the chamber 10. Thereafter, the upper lid 11 is closed via the opening and closing mechanism (not illustrated), and the chamber 10 is sealed.

When the substrate WS is set on the heating section 20 and the chamber 10 is sealed, the controller 50 opens the discharge control valve 39v, which discharges the gas in the chamber 10 (a primary vacuum discharge step: S3). At this time, from a perspective of preferably diffusing the formic acid F during supply of the formic acid F, which will be described below, the degree of vacuum is preferably increased to be high, and in this embodiment, the inside of the chamber 10 is set at approximately 100 Pa (the absolute pressure). Here, when the degree of vacuum in the chamber 10 is increased, the contained material B in the substrate WS would possibly spatter if the temperature in the chamber 10 was excessively high. However, since the temperature of the heating section 20 is the first predetermined temperature, it is possible to prevent the contained material B from spattering (bumping). When the chamber 10 reaches a predetermined degree of vacuum, the controller 50 closes the discharge control valve 39v. Thereafter, the controller 50 increases output of the lamp 22 and increases the temperature of the substrate WS to a second predetermined temperature (a temperature increase step: S4). Here, the second predetermined temperature is an appropriate set value that is lower than the melting temperature of the solder S contained in the solder agent SB and at which the oxides on the substrate WS can be reduced. The second predetermined temperature is preferably as high as possible within a permissible range. In this embodiment in which the formic acid F is used as the reducing agent, the second predetermined temperature is set at 200 °C but can appropriately be changed according to a condition. In addition, the second predetermined temperature is not limited to a single point and may vary within a certain range. The temperature of the substrate WS may be estimated from the temperature detected by the temperature sensor 41 on the basis of actual measured data. In the case where a temperature change of the plate 21 can be equated with that of the substrate WS, the temperature detected by the temperature sensor 41 may be treated as the temperature of the substrate WS. When the temperature of the substrate WS reaches the second predetermined temperature, materials in the contained material B, which possibly become residues after soldering, all become gas.

After increasing the output of the lamp 22, the controller 50 opens the formic acid control valve 34 to supply the gaseous formic acid into the chamber 10, which executes the reduction processing to reduce by the formic acid F the oxide films formed on the solder S, the surface of the substrate body W, and the like in the substrate WS (a reduction step: S5). In this embodiment, since the formic acid F is supplied into the chamber 10 that is vacuumed, the formic acid F is favorably diffused, and the appropriate reduction processing is executed. The reduction processing is executed when the formic acid is supplied into the chamber 10 and the temperature of the substrate WS is the reduction temperature. Accordingly, in the example illustrated in FIG. 2, the temperature of the substrate WS is increased to the second predetermined temperature, and then the formic acid F is supplied into the chamber 10 in this order. However, the temperature of the substrate WS may be increased to the second predetermined temperature after the formic acid F starts being supplied into the chamber 10. Alternatively, the temperature of the substrate WS may start being increased to the second predetermined temperature at the same time as when the formic acid F starts being supplied into the chamber 10.

After the reduction processing of the substrate WS is completed, the controller 50 further increases the output of the lamp 22, which heats the substrate WS to the third predetermined temperature to cause the solder S to melt (a melting step: S6), and solder joint is performed. Here, the third predetermined temperature is an appropriate set value that is equal to or higher than the melting temperature of the solder S, and is preferably as low as possible within a permissible range from a perspective of suppressing an energy consumption amount and convenience of subsequent cooling. In this embodiment, the third predetermined temperature is set at 330 °C but can appropriately be changed according to a condition. In addition, the third predetermined temperature is not limited to a single point and may vary within a range. In addition to heating of the substrate WS to the third predetermined temperature, the controller 50 opens the discharge control valve 39v, which discharges the gas in the chamber 10, and thereby produces a vacuum in the chamber 10 (a secondary vacuum discharge step: S7). By creating a vacuum in chamber 10 at the time when the solder S melts, it is possible to suppress generation of a void (cavity) in the solder S. This vacuum in the chamber 10 may be generated before the temperature of the substrate WS reaches the third predetermined temperature, depending on a situation. Although the degree of vacuum in the chamber 10 may be the same as that in the primary vacuum discharge step (S3), it can be enough to suppress generation of the void in the solder S.

After the solder joint is finished, the controller 50 turns off the lamp 22 and opens the cooling control valve 38 to supply the cooling fluid C via the cooling nozzle 36 into the chamber 10, which forcibly cools the heating section 20 and the substrate WS (a forcible cooling step: S8). Thereafter, when the temperature of the substrate WS is decreased to a temperature at which the solder S that had been melted is solidified, the controller 50 has the chamber 10 opened and the robot hand (not illustrated) take out the substrate WS from the heating section 20 (S9). This completes manufacture of the single soldered substrate. Taking out the substrate WS from the heating section 20 means that the substrate WS is brought into a state where the substrate WS does not receive the heat from the heating section 20. In this embodiment, the substrate WS is forcibly cooled by using the cooling fluid C (S8). Thus, compared to a case of not forcibly cooling, it is possible to reduce the time until the substrate WS is taken out, and it is thus possible to reduce the overall processing time. After the substrate WS is taken out from the heating section 20, the controller 50 determines whether the controller 50 has received a command to finish manufacture of the soldered substrate (S10). If not receiving the command, the plate 21 is maintained at the first predetermined temperature (S11). Then, in order to process the next substrate WS, the processing returns to the step of determining whether the temperature of the plate 21 is the first predetermined temperature (S1). Thereafter, the above-described flow is repeated. On the other hand, if the command has been received in the step of determining whether the command to finish the manufacture of the soldered substrate is received (S10), the manufacture is finished.

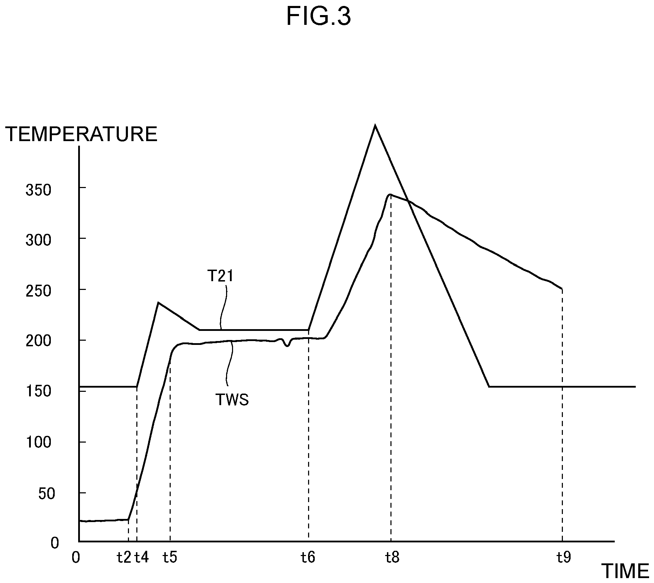

Here, with also reference to FIG. 3, a description will be made on a temperature profile in the above-described method. In a graph in FIG. 3, a vertical axis represents a temperature, and a horizontal axis represents time. The temperature of the substrate WS (hereinafter referred to as a "substrate temperature TWS") is the ordinary temperature until time t2, and this means that the substrate WS is not set on the heating section 20. By this time t2, the temperature of the plate 21 (hereinafter referred to as a "plate temperature T21") becomes the first predetermined temperature (150 °C in this embodiment). When the substrate WS is placed on the heating section 20 at the time t2, the substrate temperature TWS starts being increased. Then, in order to set the substrate temperature TWS to the second predetermined temperature (200 °C in this embodiment), at time t4, the plate temperature T21 starts being increased. When the substrate temperature TWS reaches the second predetermined temperature at time t5, the reduction processing of the oxide films formed on the solder S, the surface of the substrate body W, and the like is started. The substrate temperature TWS is maintained at the second predetermined temperature until the reduction processing is completed. Then, at time t6 after the reduction processing is finished, in order to set the substrate temperature TWS at the third predetermined temperature (330 °C in this embodiment), the plate temperature T21 starts being increased. The substrate temperature TWS is increased along with the increase in the plate temperature. The substrate temperature TWS reaches the melting temperature of the solder S in a process of reaching the third predetermined temperature, the solder S starts melting, and soldering is performed. When soldering is finished at time t8, the substrate WS starts being cooled. At time t9 of a time point at which the substrate temperature TWS is decreased to be equal to or lower than a solidification temperature of the solder S that had been melted, the substrate WS is taken out from the chamber 10.

The manufacturing method according to this embodiment having the above-described temperature profile has the following advantages. Since the temperature of the heating section 20 is increased to the first predetermined temperature before placement of the substrate WS on the heating section 20, compared to the related art, it is possible to reduce a time period from time at which the substrate WS is set on the heating section 20 to time at which a substrate temperature TWS reaches the second predetermined temperature. In addition, at the time point at which the substrate temperature TWS becomes equal to or lower than the solidification temperature of the solder S after the completion of soldering, the substrate WS is taken out of the chamber 10. Thus, it is possible to speed up completion of one cycle. Meanwhile, the conventional manufacturing method, in which the substrate is placed on the plate and then the temperatures of the substrate and the plate are increased together, has the following circumstances. In the conventional manufacturing method, the heat generated by the heat generation section is used to increase the temperatures of both of the substrate and the plate. Thus, a gradient of the temperature increase (a temperature increase width per unit time) is gentler than that in the manufacturing method according to this embodiment, and the time required until the temperature is increased to be suited for the reduction processing is longer than that in the manufacturing method according to this embodiment. In the conventional manufacturing method, the substrate is taken out of the chamber after the temperatures of both of the substrate and the plate are decreased to a temperature near the ordinary temperature. Thus, the time required to take out the substrate from the chamber after the completion of soldering is longer than that in the manufacturing method according to this embodiment. Due to presence of the above-described difference between the manufacturing method according to this embodiment and the conventional manufacturing method, in the manufacturing method according to this embodiment, it is possible to reduce the processing time to approximately 2/3 of the time in the conventional manufacturing method, for example.

In the description that has been described so far, according to the soldering device 1 and the method for manufacturing the soldered substrate according to this embodiment, the substrate WS is set on the heating section 20 that has been heated to the first predetermined temperature, which is lower than the reduction temperature, and next, the temperature of the substrate WS is increased to the second predetermined temperature. In this way, it is possible to reduce the time required to increase the temperature of the substrate WS to the reduction temperature while preventing spattering of the contained material B contained in the solder agent SB. Thus, it is possible to reduce the processing time required to manufacture the soldered substrate. In addition, since the substrate WS is taken out of the chamber 10 at a time point that the temperature of the substrate WS is decreased to be equal to or lower than a solidification temperature after completion of soldering, it is possible to further reduce the processing time. Then, the temperature of the heating section 20 is maintained at the first predetermined temperature until the next substrate WS is set on the heating section 20 after the substrate WS is taken out of the chamber 10. In this way, it is possible to eliminate the standby time when the substrate WS to be processed is switched, and it is also possible to cut an amount of the energy that is required to increase the temperature of the heating section 20 to the first predetermined temperature, such energy being required when the temperature of the heating section 20 becomes lower than the first predetermined temperature.

In the description that has been described so far, the heating section 20 has the plate 21 and the lamp 22. However, it may be configured that, instead of the lamp 22, a heater may be installed in the plate 21.

In the description that has been made so far, the gas is used as the cooling fluid C that is supplied into the chamber 10 from the cooling section 35. However, in order to increase a heat capacity, a liquid (typically, water) may be used. In the case where the liquid is used as the cooling fluid C, instead of the cooling nozzle 36, a cooling tube or coil should be provided at a position next to the heating section 20 in the chamber 10, and it should be configured that the cooling pipe 37 is connected to this cooling tube or coil. Here, the soldering device 1 includes the cooling section 35. However, in the case where cooling is not forcibly performed and natural cooling is adopted, the cooling section 35 may not be provided.

In the description that has been made so far, the second predetermined temperature is the higher temperature than the first predetermined temperature, which prevents the contained material B from spattering when the substrate WS is placed on the plate 21. However, in the case where the contained material B does not spatter even when the substrate WS is set on the plate 21, the temperature of which has been increased to the reduction temperature in advance, the second predetermined temperature may be set as the same temperature as the first predetermined temperature, and thus the processing time may further be reduced.

In the description that has been made so far, the soldering device 1 is the device that executes the reflow processing on the substrate W having the electronic component P and the solder agent SB. However, the soldering device 1 may be a device that forms a solder bump for mounting the electronic component P. Here, the solder bump is the bump that has a hemispherical surface and thus is suited to be used in the reflow soldering step when the electronic component is mounted on the substrate. The device for forming the solder bump is a device that forms the solder bumps from raw solder that is arranged on the substrate and is yet to become hemispherical.

In the description that has been made so far, the formic acid F is used for the reduction processing of the oxide films on the substrate WS and the solder S. However, the reduction processing of the oxide films on the substrate WS and the solder S may be executed by using carboxylic gas other than the formic acid as the reducing agent.

In the description that has been made so far, the soldering device and the method for manufacturing a soldered substrate according to the embodiments of the present disclosure have been described mainly with reference to FIGs. 1 to 3 as the example. However, the configurations, structures, numbers, arrangements, shapes, materials, and the like of each of the sections are not limited to the above specific example. The components that are appropriately and selectively adopted by the person skilled in the art are included in the scope of the present invention as long as the gist of the present invention is included.

All references, including publications, patent applications, and patents, cited herein are hereby incorporated by reference to the same extent as if each reference were individually and specifically indicated to be incorporated by reference and were set forth in its entirety herein.

The use of the terms "a" and "an" and "the" and similar referents in the context of describing the invention (especially in the context of the following claims) is to be construed to cover both the singular and the plural, unless otherwise indicated herein or clearly contradicted by context. The terms "comprising," "having," "including," and "containing" are to be construed as open-ended terms (i.e., meaning "including, but not limited to,") unless otherwise noted. Recitation of ranges of values herein are merely intended to serve as a shorthand method of referring individually to each separate value falling within the range, unless otherwise indicated herein, and each separate value is incorporated into the specification as if it were individually recited herein. All methods described herein can be performed in any suitable order unless otherwise indicated herein or otherwise clearly contradicted by context. The use of any and all examples, or exemplary language (e.g., "such as") provided herein, is intended merely to better illuminate the invention and does not pose a limitation on the scope of the invention unless otherwise claimed. No language in the specification should be construed as indicating any non-claimed element as essential to the practice of the invention.

Preferred embodiments of this invention are described herein, including the best mode known to the inventors for carrying out the invention. Variations of those preferred embodiments may become apparent to those of ordinary skill in the art upon reading the foregoing description. The inventors expect skilled artisans to employ such variations as appropriate, and the inventors intend for the invention to be practiced otherwise than as specifically described herein. Accordingly, this invention includes all modifications and equivalents of the subject matter recited in the claims appended hereto as permitted by applicable law. Moreover, any combination of the above-described elements in all possible variations thereof is encompassed by the invention unless otherwise indicated herein or otherwise clearly contradicted by context.

## Claims

1. A method for manufacturing a soldered substrate, the soldered substrate being a substrate soldered by a solder agent, the solder agent containing solder and a contained material, the contained material being able to be boiled at a temperature lower than a melting temperature of the solder, the method comprising:
setting a substrate onto a heat generation body heated at a first predetermined temperature, wherein the first predetermined temperature is lower than a boiling point of the contained material and higher than an ordinary temperature;
increasing a temperature of the substrate, which has been set on the heat generation body, to a second predetermined temperature, wherein the second predetermined temperature is lower than the melting temperature of the solder and is a temperature at which an oxide on the substrate can be reduced;
reducing, in the presence of a reducing agent, the oxide on the substrate, which has been heated to the second predetermined temperature; and
after reducing the oxide on the substrate, melting the solder by heating the substrate, which has been set on the heat generation body, to a third predetermined temperature, wherein the third predetermined temperature is equal to or higher than the melting temperature of the solder.

2. The method of claim 1, wherein:
the contained material includes a solvent, wherein the solvent is able to be boiled at a temperature higher than the first predetermined temperature and equal to or lower than the second predetermined temperature, and
the first predetermined temperature is lower than the second predetermined temperature.

3. The method of claim 1 or claim 2, further comprising:
taking out the substrate from the heat generation body after melting the solder and before the temperature of the substrate is decreased to the second predetermined temperature.

4. The method of claim 3, further comprising:
maintaining the temperature of the heat generation body to be equal to or higher than the first predetermined temperature after taking out the substrate and until a next substrate, that is to be processed subsequent to the substrate taken out in the taking out of the substrate, is set on the heat generation body.

5. A soldering device comprising:
a heating section configured to heat a substrate having a solder agent, wherein the solder agent contains solder and a contained material, and the contained material is able to be boiled at a temperature lower than a melting temperature of the solder;
a chamber configured to accommodate the heating section, wherein the chamber is sealable;
a reducing agent supply section configured to supply a reducing agent into the chamber, wherein the reducing agent reduces an oxide on the substrate; and
a controller configured to control a temperature of the heating section and supply of the reducing agent into the chamber,
wherein the controller controls the heating section and the reducing agent supply section in a manner to: heat the heating section to a first predetermined temperature before the substrate is set onto the heating section, wherein the first predetermined temperature is lower than a boiling point of the contained material and higher than an ordinary temperature; heat the heating section to increase a temperature of the substrate to a second predetermined temperature after the substrate is set on the heating section that has been heated to the first predetermined temperature, wherein the second predetermined temperature is a temperature lower than the melting temperature of the solder and is a temperature at which the oxide on the substrate can be reduced; supply the reducing agent into the chamber that has accommodated the substrate that has been heated to the second predetermined temperature; and heat the heating section such that the temperature of the substrate reaches a third predetermined temperature after the oxide on the substrate is reduced, wherein the third predetermined temperature is equal to or higher than the melting temperature of the solder.
